Europäisches Patentamt

European Patent Office

Office européen des brevets

(19)

(11) Veröffentlichungsnummer: **0 239 929**
**A2**

## (12) EUROPÄISCHE PATENTANMELDUNG

(21) Anmeldenummer: 87104443.4

(22) Anmeldetag: 25.03.87

(51) Int. Cl.⁴: **G01R 31/28**

(30) Priorität: 27.03.86 US 845220

(43) Veröffentlichungstag der Anmeldung:
07.10.87 Patentblatt 87/41

(84) Benannte Vertragsstaaten:
AT DE FR GB IT NL

(71) Anmelder: **Siemens Aktiengesellschaft Berlin
und München**
**Wittelsbacherplatz 2**
**D-8000 München 2(DE)**

(72) Erfinder: **Daniels, Stuart F., Dr.**
**103 Ramblewood Road**
**Moorestown, NJ 08057(US)**

(54) **Integrierte Schnittstellenschaltung für Analog-Digital-Schaltungen.**

(57) Zu Test-und Simulationszwecken wird eine Schnittstelle und ein Abtastsignalweg zwischen extern zugänglich analogen Schaltungen (51, 52) und einer internen digitalen Schaltung (53) einer integrierten Schaltung angeordnet. Eine modulare Blockbausteinmethode wird für eine Vielzahl von Schaltungseinheiten eingesetzt, die je zwei Signalwege bieten. Der erste Signalweg stellt die Durchlaßrichtung dar und wird während des normalen Arbeitsablaufs der integrierten Schaltung verwendet. Der zweite Signalweg verbindet die Schaltungseinheiten seriell miteinander, um Zugriff zu den Schnittstellen zwischen den verschiedenen Schaltungsteilen der integrierten Schaltung zu haben und um wahlweise eingesetzt zu werden, um Zugriff zu besonderen Teilen der Schaltungsanordnung für Testzwecke zu besitzen.

FIG 7

EP 0 239 929 A2

## Integrierte Schnittstellenschaltung für Analog-Digital-Schaltungen

Die Erfindung betrifft eine integrierte Schaltung nach dem Oberbegriff des Anspruchs 1. Weiterhin wird eine integrierte Schnittstellenschaltung zur Auswertung und zum Testen von Analog/Digital-Schaltungen vorgestellt. Insbesondere bezieht sich die Erfindung auf die nutzbare Anwendung von solchen Schaltungen, die einen Zugang zu den Schnittstellen zwischen analogen und digitalen Schaltungsteilen in einer integrierten Schaltung ermöglichen, wobei eine solche Schaltung sowohl digitale als auch analoge Schaltungsteile enthalten kann, und wobei die letzteren den normalen Ein- und Ausgang der integrierten Schaltung bilden.

Mit den Fortschritten der integrierten Schaltungstechnik gibt es neue Bestrebungen, normale standardisierte Bausteine oder Zellen mit komplexen Funktionen auszustatten. Andere Bestrebungen gehen dahin, analoge und digitale Schaltungen zu einem einzigen integrierten Schaltkreis zu kombinieren, um so zu ermöglichen, daß jeder Schaltungstyp für die Funktion eingesetzt werden kann, für die er sich am besten eignet. Solche kombinierte Schaltungen werden als sog. Hybrid-Schaltungen bezeichnet. Das Austesten von Hybrid-Schaltungen ist aus zweierlei Gründen notwendig: Erstens um zu überprüfen, ob der neue Chipentwurf die beabsichtigten Spezifikationen enthält, und zweitens, um zu überprüfen, ob die Qualität und die Leistung des hergestellten Chips mit dem Entwurf übereinstimmt. Im folgenden wird der Begriff "Auswertung" auf die Bestimmung der Leistung des vorgeschlagenen Chipentwurfs bezogen und der Begriff "Testen" wird verwendet für das Auswerten und das Messen der Leistung des hergestellten Chips.

Analoge Funktionsschaltungen werden häufig durch mathematische Beziehungen, die analytische Funktionen der Zeit oder der Fre quenz sind, beschrieben. Digitale Funktionsschaltungen werden immer durch eine begrenzte Tabelle von Einzelmöglichkeiten ausgedrückt (Ist-Zustand, Ist-Eingangssignal, nächstes Eingangssignal), im allgemeinen Sprachgebrauch als Zustandstabelle oder für kombinierte Schaltungen als Wahrheitstabelle bezeichnet. Eine Computersimulation kann dabei zum einen zur Auswertung, zum anderen zum Entwurf von Testprogrammen für ein automatisches Testen eingesetzt werden. Für analoge Schaltungen können ungenaue Schaltungsmodelle benutzt werden, um eine schnelle, idealisierte Schaltungsauswertung zu erreichen. Diese weniger genauen Schaltungsmodelle basieren auf idealen Strom-/Spannungsquellen und passiven Bauelementen. Andere Möglichkeiten zur Simulation analoger Schaltungen ergeben sich unter Verwendung genauer, detaillierter, zeitlich kontinuierlicher Schaltungsmodelle, die die nicht linearen Eigenschaften der Bauelemente und Schaltungen hervorheben. Für digitale Schaltungen werden diskrete Zeitmodelle verwendet, die auf diskreten mathematischen Modellen von digitalen Bauelementen aufbauen. Für hochkomplexe Schaltungen im gegenwärtigen Entwicklungsstadium der integrierten Schaltungstechnologie können analoge Schaltungsfunktionen in sehr kompakter mathematischer Art und Weise beschrieben werden, wo hingegen das Verhalten digitaler Schaltungen eine umfangreiche Menge von Einzeldaten erfordert. In beiden Fällen verringert die Verfügbarkeit einer begrenzten Anzahl von Anschlüssen oder Schaltungspins die Fähigkeit zum Zugriff auf das Innere der Schaltung und damit das genaue und gesamte Auswerten und Testen der Leistung der Schaltung.

Automatische digitale Auswertung und Testtechniken sind hinreichend bekannt. Eine analoge Schaltungsauswertung und Testtechniken haben sich nicht im gleichen Ausmaß entwickeln können. So mangelt es bei der hybriden Schaltungsauswertung und Testung, sogar dann wenn die Schaltungsteile eigenständig und unabhängig voneinander arbeiten, an Hilfsmitteln, die die Simulation, Auswertung und die Tests unterstützen; ungeachtet der Tatsache einer wachsenden Anzahl von hybriden Bauelementen, die entwickelt und benutzt werden.

Den vorhergegangenen Abschnitten lag die Annanme zugrunde, daß kein Rückkopplungszweig vorhanden war. Wenn Rückkopplungszweige benutzt werden, ist jedoch die Annahme der Unabhängigkeit bei Schaltungsteilen voneinander nicht mehr gültig. Zwei Untersuchungsvorgänge, einen für den analogen, einen anderen für den digitalen Teil müssen gleichzeitig durchgeführt werden. Aber es gibt einen grundlegenden Unterschied in den Zielen und somit in den Methoden zum Untersuchen von Schaltungen im Vergleich zwischen analogen und digitalen Schaltungen. Demgemäß müssen bedeutsame hybride Auswertungshilfsmittel beide unterschiedlichen Techniken verarbeiten können. Gemäß der eingeführten gegenseitigen Abhängigkeit bei den hybriden Schaltungsanordnungen erbringen gegenwärtige Auswertungen und Testtechniken nicht die hohen Qualitätsanforderungen und effizienten Resultate für hybride Auswertungshilfsmittel. In allen Auswertungs-und Testtechniken gibt es ein eindeutiges Verlangen nach einem gesteigerten möglichen Zugriff auf die Schaltung mit den Anforderungen, daß die Eignung zu einem kommerziellen Produkt nicht geschmälert wird.

Die wichtigste Aufgabe dieser Erfindung liegt darin, eine abtastende Schnittstellenschaltung für den Zugriff auf digitale Schaltungen vorzustellen, die normalerweise mit analogen Eingangs/Ausgangsschaltungen in einer hybriden integrierten Schaltung verbunden ist, um so Simulation und Schaltungsauswertungen und Schaltungstests vornehmen zu können. Eine weitere Aufgabe dieser Erfindung besteht darin, daß die abtastende Schnittstelle, die im multiplexen Betrieb betrieben wird, eine vielfache Nutzung der begrenzten Anzahl von Schaltungspins oder Anschlüssen ermöglichen soll und damit eine gesteigerte Testzugriffsmöglichkeit und eine erhöhte Auswertungsgenauigkeit gestatten soll. Es ist weiterhin Zweck dieser Erfindung, einen Abtastsignalweg an der Schnittstelle zwischen digitalem und analogen Schaltungsteil aufzuzeigen, der eine Entkopplung der zwei verschiedenen Schaltungstypen ermöglicht und dadurch den Entwurfs-und den Auswertungsprozeß erleichtern soll. Es sollen durch die vorliegende Erfindung die Testmöglichkeiten und die gemischt betriebenen Simulationstechniken, durch definierte, einheitliche Schaltungseinheiten zwischen dem digitalen und analogen Teil des hybriden Chips verbessert werden. Weiterhin besteht eine Aufgabe der Erfindung darin, daß die Schaltungseinheiten so ausgelegt sein sollen, daß sie als spezielle Abtastsignalwege genutzt werden können, und daß sie während des Testablaufs eine Isolation zwischen dem analogen und dem digitalen Schaltungsteil der integrierten Schaltung bilden.

Diese Aufgaben werden erfindungsgemäß durch die kennzeichnenden Merkmale des Anspruchs 1 gelöst.

Weitere Ausgestaltungen der Erfindung, insbesondere zu der Realisierung der Schaltungseinheiten, ergeben sich aus den Unteransprüchen.

Die Erfindung wird durch einen Abtastsignalweg und einer Schnittstelle zwischen den externen analogen Schaltungsteilen und dem internen digitalen Schaltungsteil der integrierten Schaltung realisiert. Vorteilhaft ist hierbei, daß in der Durchgangsbetriebsart die Vielzahl der Schaltungseinheiten, und zwar jede einzelne davon, eine Vielzahl von parallelen durchgehenden Signalwegen zwischen den jeweils beteiligten Schaltungsteilen liefern. In der Abtastbetriebsart wird ein zweiter Signalweg aufgebaut, der die Vielzahl von Schaltungseinheiten untereinander in serieller Anordnung verbindet. Während der Abtastbetriebsart kann eine Taktung benutzt werden, um die aufeinanderfolgenden Informationen für die verschiedenen Testmöglichkeiten zu erhalten.

In einer Hinsicht kann ein Schaltungsteil der integrierten Schaltung voll wirksam während des Auswertens isoliert werden. Die Möglichkeit des Abtastsignalweges kann benutzt werden, um den Zugang zum Ausgang der analogen Eingangsschaltung zu erhalten oder um Zugang zu dem Eingang der analogen Ausgangsschaltung zu haben. Zuzüglich kann der Abtastsignalweg benutzt werden, um sich Zugang zu den Ein-und Ausgängen der internen Digitalschaltung innerhalb der integrierten Schaltung zu verschaffen.

In anderer Hinsicht nutzt die Erfindung die Vielzahl der Schaltungseinheiten in einer Durchgangsbetriebsart um eine Vielzahl von parallelen Signalwegen bereitzustellen, die während des normalen Betriebsablaufs notwendig sind. In einer anderen Betriebsart sind die Schaltungseinheiten seriell miteinander verbunden, um einen Abtastsignalweg zu bilden, die mit aufeinanderfolgenden Taktimpulsen versorgt werden, um einen selektiven Zugriff zur Schaltungsbetriebsart oder intern zur integrierten Schaltung zu haben.

Weiterhin wird in der Erfindung ein allen gemeinsamer ähnlicher Blockbaustein für die Schaltungseinheiten verwendet, wobei eine vorhandener Schmitt-Trigger am Eingangsteil der grundsätzliche Unterschied zwischen der analogen und der digitalen Ausführung der Schaltungseinheiten ist. Eine solche Anordnung erleichtert die Herstellungs-und Fabrikationsbedingungen für die integrierte Schaltung.

Die Möglichkeiten der Erfindung und die zusätzlichen Merkmale zur Erfindung werden durch den Hinweis auf die folgende detaillierte Beschreibung, die in Zusammenhang mit den Zeichnungen betrachtet werden soll, schnell richtig eingeschätzt und besser verstanden.

Figure 1 zeigt eine allgemeine Übersichtzeichnung einer integrierten Hybridschaltung,

Figur 2 zeigt eine allgemeine Übersichtszeichnung einer integrierten Hybridschaltung mit gegenseitiger funktioneller Abhängigkeit,

Figur 3 zeigt einen ersten Schnittstellenbaustein mit analogen Eingang und digitalem Ausgang,

Figur 4 zeigt einen zweiten Schnittstellenbaustein mit digitalem Eingang und analogem Ausgang,

Figur 5 zeigt ein Blockschaltbild des Schnittstellenbausteins von Figur 3,

Figur 6 zeigt ein Blockschaltbild des Schnittstellenbausteins von Figur 4,

Figur 7 gibt ein Blockschaltbild wieder, das eine typische Anwendung der Schnittstellenbausteine in einer integrierten Hybridschaltung illustriert.

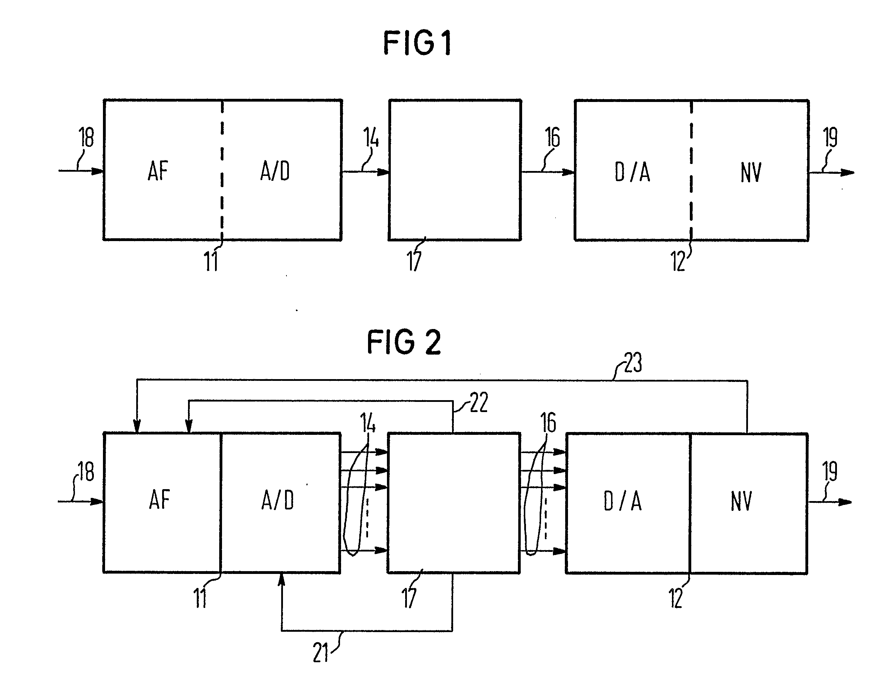

Figur 1 gibt ein Blockschaltbild eines typisch integrierten Hybridbausteins oder Chips wieder, der analoge Schnittstellenbereiche 11 und 12 aufweist. Die Schnittstellenbereiche 11 und 12 sind Schaltungsbereiche im Chip, die jeweils digitale Eingangssignale über die Verbindungsleitung 14 anlegen oder digitale Ausgangssignale von der digitalen Logikschaltung 17 über die Verbindungsleitung 16 aufnehmen. Typische Funktionen der Schnittstellenbereiche 11 würden eine analoge Filterung AF und eine Analog/Digitalwandlung A/D beinhalten. Ähnlich übliche Funktionen würden die Schnittstellenbereiche 12 beinhalten, dies könnte ein Digital/Analogwandler D/A und ein nichtlinearer Verstärker mit einem Tiefpaßfilter NV sein. Andere typische Funktionen, wie Strom/Spannungsfrequenzumsetzung oder Strom/Spannungsphasenschiebung am Ausgang können vorgesehen werden. Sogar bei annähernd linearen Funktionen ergeben sich bei der Simulation zur Schaltungsentwurfsauswertung und bei den Tests Schwierigkeiten durch die begrenzte Zugriffsmöglichkeit über den Eingangsport 18 und Ausgangsport 19. Es ist für den Durchschnittsfachmann wohl offensichtlich, daß die digitale Logikschaltung 17 auch direkte digitale Eingangs-und Ausgangssignale ohne Verluste verarbeiten kann, die nicht an die analogen Schnittstellenbereiche 11 und 12 angeschlossen sind. Diese sind in der Beschreibung nicht weiter ausgeführt.

Der Schaltungsaufbau in Figur 2 ist dem Aufbau in Figur 1 grundsätzlich ähnlich. Jedoch beinhaltet sie zusätzlich eine Sample-rate-control-Rückführung 21 und eine Gain-control-Rückführung 22, 23. Es solte angeführt werden, daß die gleichen Bezugszeichen in beiden Figuren 1 und 2 gemeinsam benutzt werden, um korrespondierende Teile aufzuzeigen. Gemäß dem Vorhandensein dieser typischen Rückführungen werden die Schnittstellenbereiche 11 und 12 mit der digitalen Logikschaltung 17 in Figur 2 untereinander funktionell abhängig. Dies macht die Aufgabe der Auswertung und der Tests für die Schaltung in Figur 2 - schwieriger als für die in Figur 1.

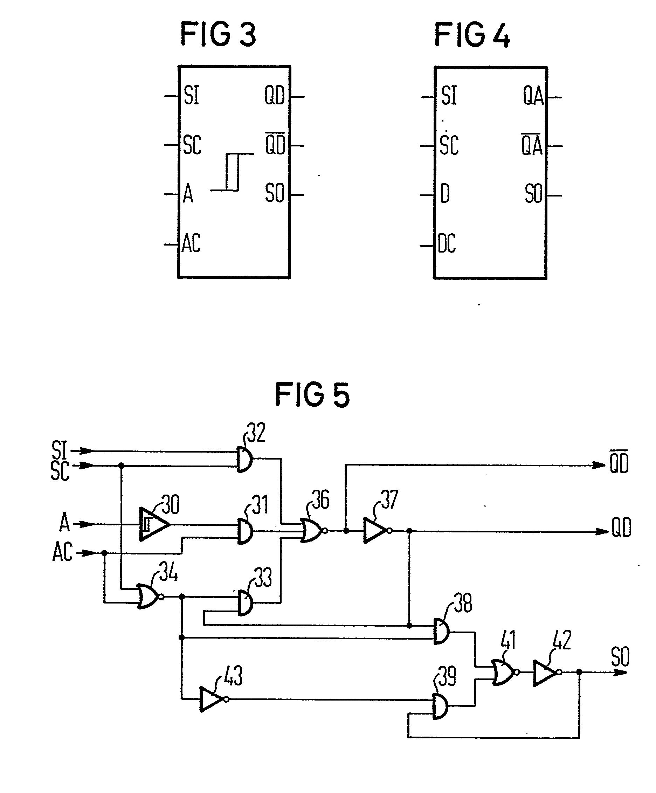

Die Figuren 3 und 4 stellen Schnittstellenbausteinsymbole oder Schaltungseinheiten dar, die die Funktionen im Zusammenhang mit den erfindungsgemäßen Überlegungen ausführen. Auf der linken Seite werden die Eingangssignale angelegt und Ausgangssignale sind an der rechten Seite jeder Schaltungseinheit abgreifbar. Die Bezeichnungen für die Bezugszeichen, die in Figur 3 und 4 benutzt werden, sind:

SI - Scan Dateneingang
SC - Scan Clock
A - Analoger Dateneingang
AC - Analog Clock
D - Digitaler Dateneingang
DC - Digital Clock
SO - Scan Ausgang
QD, $\overline{QD}$ -Digitaler Datenausgang (2 Leitungen)
QA, $\overline{QA}$ -Analoger Datenausgang (2 Leitungen).

Diese Bezeichnungen werden durchgängig für die verbleibenden Figuren und in der zugehörigen Beschreibung verwendet. Auch werden ähnliche Bauelemente in den verschiedenen Zeichnungen mit den gleichen Bezugszeichen versehen, um ein Verständnis der Schaltungsfunktionen zu erleichtern.

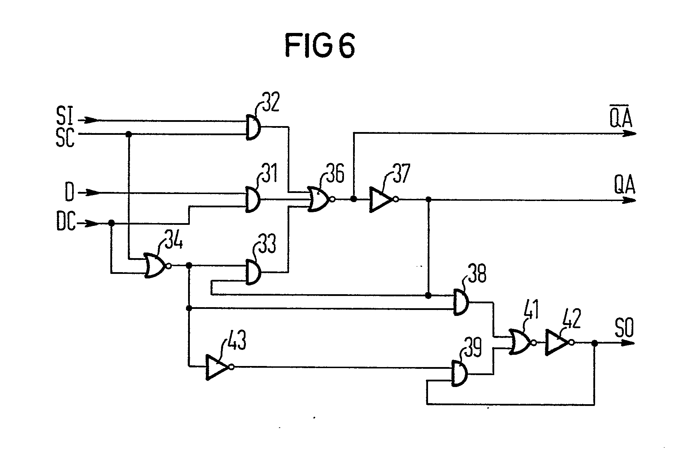

Die Figuren 4 und 6 zeigen Blockschaltbilder mit standardisierten Logikbauelementen. Der wichtigste Unterschied zwischen den beiden besteht darin, daß der analoge Dateneingang A der Schaltung in Figur 5 mit den AND-Gatter 31 über einen Schmitt-Trigger 30 verbunden ist, während in der Schaltung in Figur 6 der digitale Dateneingang D direkt mit dem Eingang des AND-Gatters 31 verbunden ist. Der Schmitt-Trigger 30 dient dazu, mögliche langsame und jitternde analoge Signalflanken in schnelle, saubere Digitalübergänge zu übertragen. Auch sollte der Schmitt-Trigger 30 deutlich und gut kontrollierbare Unter scheidungsschwellen liefern. Typische obere und untere Unterscheidungsschwellen sollten mit jeweils ein Drittel oder zwei Drittel der Spannung $V_{DD}$ übereinstimmen. Das analoge Takteingangssignal am Analog-Clock-Eingang AC wird an den anderen Anschluß des AND-Gatters 31 in der Schaltung von Figur 5 angelegt, während in der Schaltung von Figur 6 das digitale Takteingangssignal am Eingang Digital Clock DC benutzt wird. An einem weiteren AND-Gatter 32 werden die Eingangssignale an den Scan Dateneingang SI und den Scan Clock Eingang SC angelegt. Das verbleibende AND-Gatter 33 in dem Eingangsbereich besitzt ein Eingang, der für den Ausgang des Exklusiv-NOR-Gatters 34, das mit dem Takteingangssignal versorgt wird, vorgesehen ist. Der andere Eingang des AND-Gatters 33 ist mit dem digitalen Datenausgang verbunden.

Die AND-Gatter 31 bis 33 belegen je einen Eingang des NOR-Gatters 36, der einen negierten Datenausgang und einen regulären Datenausgang über den Inverter 37 versorgt. Der Scan-Ausgang SO ist an eine Schaltung mit dem AND-Gatter 38 und 39, dessen Ausgänge an das NOR-Gatter 41 gelegt sind und dann durch den Inverter 42 invertiert werden, angeschlossen. Das AND-Gatter 38 ist mit seinem ersten Eigang mit dem Datenausgangssignal und mit seinem zweiten Eingang mit dem Ausgang des NOR-Gatters 34 verbunden. Für das AND-Gatter 39 wird der erste Eingang durch den zuletzt genannten Ausgang, jedoch nun über den Inverter 43 invertiert, versorgt. Der verbleibende Eingang zum Gatter 39 ist verbunden mit dem Scan-Ausgang SO.

Die Schnittstellenbausteinanordnung der Figuren 5 und 6 dienen als Durchgangslatchs. Dies ermöglicht die Flexibilität, sie als einfache Pufferverstärker, die keine Taktsignale zur Versorgung benötigen, einzusetzen oder andererseits als Informationsspeicherbausteine. Jeder Baustein beinhaltet ein Slave latch, dessen Scan-Ausgang SO mit dem Master latch verschaltet ist, um eine Schiebekapazität für die Abtastbetriebsart zu ermöglichen. In der Abtastbetriebsart empfängt eine Zelle ihre Daten am Scan-Dateneingang SI von dem Scan-Ausgang SO der vorhergehenden Zelle.

Das Master latch beinhaltet die Konfiguration aus NOR-Gatter 36, Inverter 37 und AND-Gatter 33, dessen Ausgang den Rückkopplungszweig zum dritten Eingang des NOR-Gatters 36 bildet. Die Konfiguration des Slave latchs beinhaltet das NOR-Gatter 41, das mit dem Ausgang des AND-Gatters 38 verbunden ist, den Inverter 42 und das AND-Gatter 39. Über das Gatter 39 wird der Rückkopplungszweig zum anderen Eingang des NOR-Gatters 41 geschlossen.

Im Normalbetrieb der Schaltung ist der Scan Clock Eingang SC auf logisch "0" oder "low" gelegt, während der Digital Clock Eingang DC auf "high" oder logisch "1" liegt. Abweichend davon kann der Digital Clock Eingang DC getaktet werden, um den Betrieb in der Abtastbetriebsart herzustellen. In der ersten Kombination von Eingangssignalen sperrt das AND-Gatter 32, öffnet das AND-Gatter 31 und sperrt das AND-Gatter 33. in dieser Betriebsart ist die Schaltung von Figur 6 durchlässig und gibt das Signal am digitalen Dateneingang D an die digitalen Datenausgänge QA und $\overline{QA}$ weiter, sie bildet hierbei lediglich eine Pufferfunktion. In Figur 5 wird der analoge Dateneingang A über einen Schmitt-Trigger 30 geführt und weiter zu den analogen Datenausgängen QA und $\overline{QA}$ .

In Figur 6 werden in der normalen Betriebsart ankommende Signale an dem digitalen Dateneingang D abgetastet und gespeichert. Zu diesem Zeitpunkt liegt das Signal am Scan Clock Eingang SC auf "low" und sperrt das AND-Gatter 32, um zu verhindern, daß Daten abgetastet werden. Wenn am Digital Clock Eingang DC Taktsignale anliegen, werden Daten am digitalen Dateneingang D gespeichert und an den analogen Datenausgang QA ausgelesen.

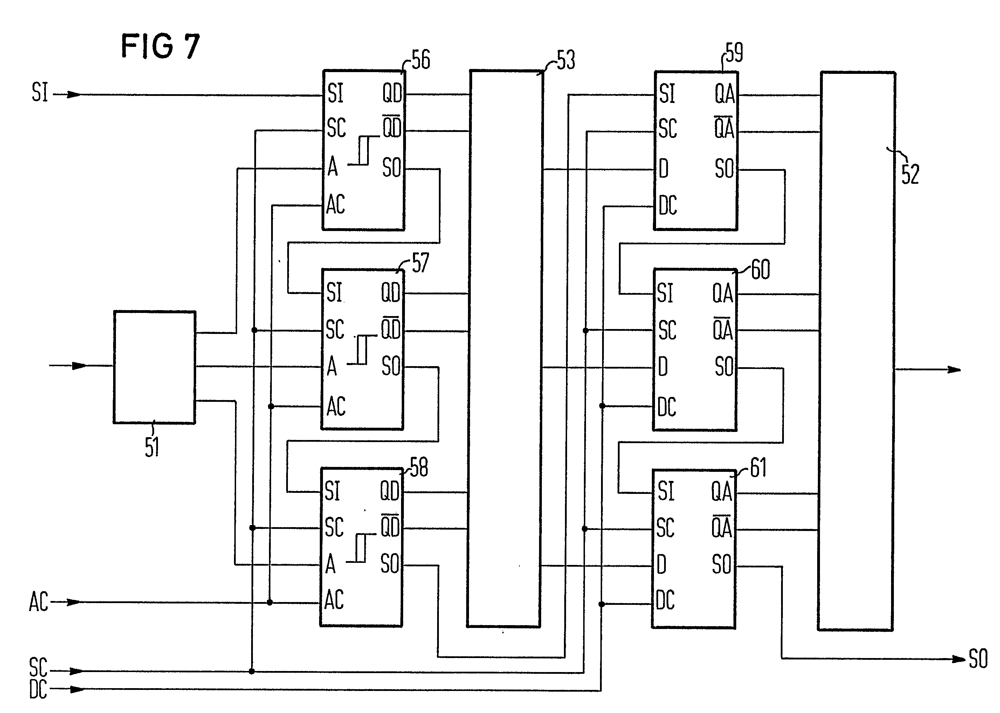

In der Abtastbetriebsart ist der Digital Clock Eingang DC auf logisch "0" gelegt und Daten am Dateneingang D werden gespeichert. Der Scan Clock Eingang SC wird dann getaktet und so können die gespeicherten Daten an dem Scan Ausgang SO ausgelesen werden. Andererseits können Daten am Scan Eingang SI an das Master latch durch Takten des Scan Clock Eingangs SC angelegt werden. Die Verwendung dieser Betriebsart wird besser verständlicher in Verbindung mit der Erörterung von der Figurenbeschreibung Figur 7.

In Figur 7 ist eine anschauliche Darstellung der Verschaltung eines Schnittstellenbausteins in einer Hybridschaltung wiedergegeben. Im Normalbetrieb wird das analoge Eingangssignal am analogen Schaltungsteil 51 angelegt und das Ausgangssignal erscheint am Ausgang des analogen Schaltungsteils 52. Einige der typischen Aufgaben der Schaltungsteile 51 und 52 sind in der Figur 1 mit den analogen Schnittstellenbereichen 11 und 12 wiedergegeben. Es sollte daher verständlich sein, daß auch andere Funktionen und Schaltungstypen hierin untergebracht werden können. Verschiedene logische Funktionen und digitale Verarbeitungsfunktionen werden mit der digitalen Schaltung 53 bearbeitet. Die Wiedergabe einer parallelen Anordnung von drei Schnittstellenbausteinen oder Schaltungseinheiten des analog/digitalen Typs 56, 57, 58 liefert eine anschauliche Schnittstellenschaltung zur Verbindung der analogen Schaltung 51 und der digitalen Schaltung 53. Ähnlich der Darstellung von drei Schnittstellenbausteinen oder Schaltungseinheiten des digitalen/analogen Typs 59, 60, 61, sie liefert die anschauliche Verbindung zwischen den Schaltungen 53 und der analogen Schaltung 52. Die jeweiligen Schnittstellenbausteine sind ausführlicher in den Figuren 5 und 6 wiedergegeben.

In der analogen Abtastbetriebsart wird durch Anlegen von logisch "0" am Digital Clock Eingang DC die Schnittstellenbausteine 56, 57, 58, 59, 60, 61 die digitale Schaltung 53 von den analogen Schaltungen 51 und 52 getrennt, während man Zugriff auf den jeweiligen Ein-und Ausgang der digitalen Schaltung 53 hat, indem man in serieller Folge das Auslesen durch Takten am Scan Clock Eingang SC bewirkt. Nachdem die gespeicherten Daten aus dem seriellen Abtastweg der Schnittstellenbausteine 56 bis 58 und 59 bis 61 ausgelesen sind, wird der nächste Datensatz an den Ausgängen der analogen Schaltung 51 durch Takten des Analog Clock Eingangs AC übernommen. Andererseits kann der analoge Clock Eingang AC mit dem Takt des digitalen Clock Eingangs DC gespeist werden und der Zugriff zu den Ausgangssignalen der analogen Schaltung 51 wird verkürzt, da die Taktsignale angelegt werden, um die gespeicherten Daten in den Schnittstellenbausteinen 56 bis 58 zu ersetzen.

In der digitalen Abtastbetriebsart wird der Analog Clock Eingang AC auf logisch "0" gelegt, um die Ausgänge der analogen Schaltung 51 so zu sperren, daß ein Eintritt dieser Ausgangssignale in die Schnittstellenbausteine 56 bis 58 nicht möglich ist. Der digitale Clock Eingang DC wird getaktet, um die gespeicherten Werte aus den Schnittstellenbausteinen 59 bis 61 an den Scan Ausgängen SO auszulesen. Zur gleichen Zeit können neue digitale Daten an den Scan Dateneingang SI durch Takten des Scan Clock Eingangs SC angelegt wird. Durch nachfolgendes Takten des Scan Dateneingangs SC in Übereinstimmung mit der Anzahl der Schnittstellenbausteine erscheint das serielle am Scan Dateneingang SI liegende Dateneingangssignal parallel zur Anwendung an allen Eingängen der digitalen Schaltung 53. Durch eine geeignete Anwendung in der Abfolge dieser Operationen wird offensichtlich, daß ein vollständiger Zugriff auf alle jeweiligen Ein-und Ausgänge des digitalen Schaltungsteils 53 zur Auswertung möglich ist. In ähnlicher Weise bietet diese Konfiguration Zugriff auf die Ausgänge der analogen Eingangsschaltung 51 sowie auf die Eingänge der analogen Ausgangsschaltung 52. In jedem Fall dient das Takten des Scan Clock Eingangs SC dazu, um seriell sequentielle Signale am Scan Ausgang SO zu erzeugen, die die Signale an der parallelen Schnittstelle der integrierten Schaltung zum Testen in dem ausgewählten Schaltungsteil bilden.

Es sollte verständlich sein, daß die Pin-oder Anschlußkonfiguration, die in Figur 7 gezeigt wird, ein Minimum an Ein/Ausgangsverbindungen benutzt. Falls gewünscht, können andere optionale Verbindungen zusätzlich eingebracht werden durch Trennen der Leitung vom Scan Ausgang SO des Schnittstellenbausteins 58 zum Scan Dateneingang SI des Schnittstellenbausteins 59 und Herausführen auf einen zusätzlichen externen Pin. Dann ist der Direktzugriff zu den Eingängen und Ausgängen der Eingangsschnittstellenbausteine 56 bis 58 und den Ausgangsschnittstellenbausteinen 59 bis 61 ermöglicht. Andere Möglichkeiten würden einen direkten Zugriff zur digitalen Schaltung 53 über eine entsprechende Anzahl von Pins wünschenswert erscheinen lassen. In dem Fall, in dem die digitale Schaltung 53 einen internen Abtastweg beinhaltet, wird die letztere Überlegung vorteilhaft sein, um einen direkten Zugriff auf die digitalen Eingangs-und Ausgangsignale zu ermöglichen, die zwei Abtastwege könnten seriell miteinander verbunden werden. Eine andere Abwandlung, die dazu dient, die Anzahl der für die Schnittstellenbausteine erforderlichen Anzahl von Schaltungen zu verringern, liegt darin, die internen Ausgangsschieberegister der analogen Schaltung 51 statt die der Schnittstellenbausteinkonfiguration 56 bis 58 zu benutzen.

Durch die verschiedenen Betriebsarten im Arbeitsablauf, die beschrieben wurden, sollte es möglich sein, in verschiedenenen Anwendungen andere Testkonfigurationen und Betriebsarten benutzen zu können, um die erforderlichen besonderen Bedingungen beim Testen von Hybridschaltungen zu erfüllen. Beispielsweise kann in einer Hybridschaltung mit einem Rückkopplungszweig die untereinander vorhandene Abhängigkeit andere Wahlmöglichkeiten erfordern, um den Auswertungs-und Testprozeß durchführen zu können. In anderen Situationen ist die Geschwindigkeit der Auswertung wichtig, so daß zusätzlich Zugriffpins benutzt werden können, um die Zeit zu reduzieren, die ein angelegtes Ein-oder Ausgangssignal braucht, bevor es durch die Taktung mit den passenden Eingängen des Schaltungsteils in Verbindung kommt.

Es wurde eine neue Schnittstellenbausteinkonfiguration gezeigt und beschrieben, die alle Wünsche und Vorteile hierfür erfüllt. Viele Änderungen, Modifikationen, Abänderungen, anderen Gebrauch und die Verwendung der betreffenden Erfindung wird jedoch dem Durchschnittsfachmann, der diese Beschreibung und die zugehörigen Beschreibung, die die vorzugsweise Darstellungen verkörpern, ersichtlich. Alle jene Änderungen, Modifikationen, Abänderungen und weiterer Gebrauch sowie die Anwendung, die nicht von den Überlegungen der Erfindung abweichen, werden durch diese Erfindung als geschützt betrachtet, die nur durch die folgenden Ansprüche begrenzt werden.

Bezugszeichenliste

11, 12 Schnittstellenbereiche
17 digitale Logikschaltung
14, 16 Verbindungsleitungen
AF Analogfilter
A/D Analog/Digital-Wandler
D/A Digital/Analog-Wandler
NV Nichtlinearer Verstärker mit Tiefpaßfilter
18 Eingangsport
19 Ausgangsport
21 Sample rate control-Rückführung
22, 23 Gain control-Rückführung
SI Scan Dateneingang
SC Scan clock
A analoger Dateneingang
AC Analog clock
D digitaler Dateneingang
DC Digital clock
SO Scan Ausgang
QD, $\overline{QD}$ digitaler Datenausgang
QA, $\overline{QA}$ analoger Datenausgang
31, 32, 33, 38, 39 AND-Gatter
30 Schmitt-Trigger
37, 42, 43 Inverter
34, 36, 41 NOR-Gatter
51, 52 analoger Schaltungsteil
53 digitale Schaltung
56, 57, 58 Schaltungseinheit des analog/digitalen Typs
59, 60, 61 Schaltungseinheit des digital/analogen Typs

**Ansprüche**

1. Eine integrierte Schaltung mit einer analogen Eingangsschaltung (51), einer analogen Ausgangsschaltung (52) und einer Digitalschaltung (53), **dadurch gekenn zeichnet,** daß die analoge Eingangsschaltung (51) und die analoge Ausgangsschaltung (52) in geeigneter Weise an die Digitalschaltung (53) angeschlossen sind, die zwischen der analogen Eingangsschaltung (51) und der analogen Ausgangsschaltung (52) verschaltet ist, daß die integrierte Schaltung Schnittstellenschaltungen umfaßt, die eine Vielzahl von seriell miteinander verbundenen Schaltungseinheiten (56, 57, 58, 59, 60, 61) beinhaltet, die zwischen der analogen Eingangs-und Ausgangsschaltung (51, 52) und der Digitalschaltung (53) angeordnet sind, daß jede Schaltungseinheit (56, 57, 58, 59, 60, 61) einen ersten Signalweg mit einem ersten Eingang (A; D) und einen ersten Ausgang (QD, $\overline{QD}$ ; QA, $\overline{QA}$ ) beinhaltet, um eine erste Durchgangsbetriebsart zu bieten, die ein Eingangssignal an dem besagten ersten Eingang (A; D) zu dem besagten ersten Ausgang (QD, $\overline{QD}$ ; QA, $\overline{QA}$ ) während des normalen Betriebs der integrierten Schaltung weiterleitet und daß jede Schaltungseinheit (56, 57, 58, 59, 60, 61) einen zweiten Signalweg mit einem zweiten Eingang (SI) und einem zweiten Ausgang (SO) beinhaltet, um Informationen speichern zu können, und um Eingangsdaten in einem Schiebemodus an den zweiten Ausgang (SO) weiterzuleiten, daß der zweite Ausgang (SO) einer solchen Schaltungseinheit mit dem zweiten Eingang (SI) der nächstnachfolgenden Schaltungseinheit verbunden ist, um einen seriellen Signalweg zu bilden, und daß der zweite Ausgang (SO) der letzten Schaltungseinheit einen externen Scan Ausgang (SO) bildet.

2. Die integrierte Schaltung nach Anspruch 1,**dadurch gekennzeichnet,** daß jede Schaltungseinheit (56...61) einen Scan clock-Eingang (SC) beinhaltet, der ein Signal am zweiten Eingang (SI) auf übernommene Eingangsdaten kontrolliert.

3. Die integrierte Schaltung nach Anspruch 1, **dadurch gekennzeichnet,** daß alle Schaltungseinheiten (56, 57, 58), die zwischen der analogen Eingangsschaltung (51) und der Digitalschaltung (52) angeordnet sind, eine erste interne Schnittstelle bilden, daß jede Schaltungseinheit (56, 57, 58) einen analogen Clock-Eingang (AC) beinhaltet, der ein Signal der analogen Eingangsschaltung (51) vom ersten Eingang (A) zum zugehörigen ersten Ausgang (QD, $\overline{QD}$ ) weiterleitet oder sperrt.

4. Die integrierte Schaltung nach Anspruch 1, **dadurch gekennzeichnet,** daß jede Schaltungseinheit (59, 60, 61), die zwischen der Digitalschaltung (53) und der analogen Ausgangsschaltung (52) angeordnet ist, einen digitalen Clock-Eingang (DC) beinhaltet, der den ersten Eingang (D), der mit der Digitalschaltung (53) verbunden ist, zu dem zugehörigen ersten Ausgang (QA, $\overline{QA}$ ) sperrt.

5. Die integrierte Schaltung nach Anspruch 1, **dadurch gekennzeichnet,** daß der Ausgang der letzten (58) der seriell miteinander verbundenen Schaltungseinheiten (56, 57, 58), die zwischen der analogen Eingangsschaltung (51) und der Digitalschaltung (53) angeordnet sind, mit der ersten (59) der seriell miteinander verbundenen Schaltungseinheiten (59, 60, 61), die zwischen der Digitalschaltung (53) und der analogen Ausgangsschaltung (52) angeordnet sind, verschaltet ist.

6. Die integrierte Schaltung nach Anspruch 3, **dadurch gekennzeichnet,** daß jede Schaltungseinheit (56, 57, 58) der ersten internen Schnittstelle eine Schmitt-Trigger-Schaltung enthält, die mit dem ersten Eingang (A) verbunden ist und die die analoge Eingabe in ein digitales Signal umwandelt.

7. Die integrierte Schaltung nach Anspruch 3, **dadurch gekennzeichnet,** daß jede Schaltungseinheit (56 ... 61) ein Master-und ein Slave-Latch enthält, daß das Master-Latch einen durchgehenden Signalweg zwischen dem ersten Eingang (A; D) und dem ersten Ausgang (QD, $\overline{QD}$ ; QA, $\overline{QA}$ ) einer jeden Schaltungseinheit (56.... 61) - schaltet, während das Slave latch ein zweites Ausgangssignal liefert, indem es so verschaltet ist, daß es dieses Signal aufnehmen kann.

8. Die integrierte Schaltung nach Anspruch 4, **dadurch gekennzeichnet,** daß der digitale Clock-Eingang (DC) getaktet wird, um eine Abtastbetriebsart des Arbeitsablaufs für die Schaltungseinheiten (59, 60, 61) zu erzeugen, die zwischen der Digitalschaltung (53) und der analogen Ausgangsschaltung (52) verschaltet sind.

9. Die integrierte Schaltung nach Anspruch 4, **dadurch gekennzeichnet,** daß der digitale Clock-Eingang (DC) auf einem logischen "I"-Pegel gehalten wird, um eine Durchgangsbetriebsart des Arbeitsablaufs zwischen der Digitalschaltung (53) und der analogen Ausgangsschaltung (52) vom ersten Eingang (D) zum ersten Ausgang (QA, $\overline{QA}$ ) einer jeden Schaltungsanordnung (59, 60, 61) zu erzeugen.

10. Die integrierte Schaltung nach Anspruch 7, **dadurch gekennzeichnet,** daß das Slave-Latch einen weiteren Eingang, zuständig für den zweiten Eingang (SI) der Schaltungseinheit, beinhaltet.

## FIG 1

## FIG 2

0 239 929

0 239 929

## FIG 3

## FIG 4

## FIG 5

FIG 6

FIG 7

0 239 929